# FASCICULE DE BREVET EUROPEEN

(11) **EP 2 718 958 B1**
(45) Date de publication et mention de la délivrance du brevet: **28.08.2019**
(21) Numéro de dépôt: 12731516.6
(22) Date de dépôt: 07.06.2012
(51) Int. Cl.: H01J 37/32, C23C 14/48

(54) **MACHINE D'IMPLANTATION IONIQUE EN MODE IMMERSION PLASMA POUR PROCÉDÉ BASSE PRESSION**
PLASMAIMMERSIONSIONENIMPLANTATIONSMASCHINE UNTER NIEDERDRUCK
PLASMA IMMERSION ION IMPLANTATION MACHINE FOR LOW-PRESSURE PROCESS

(30) Priorité: 09.06.2011 FR 1101763
(43) Date de publication de la demande: 16.04.2014
(73) Titulaire: Ion Beam Services, 13790 Peynier (FR)
(72) Inventeur: TORREGROSA, Frank, F-13109 Simiane (FR); ROUX, Laurent, F-13013 Marseille (FR)
(74) Mandataire: Cabinet Prugneau-Schaub
(86) Numéro de dépôt international: PCT/FR2012/000227
(87) Numéro de publication internationale: WO 2012/168575

(56) Documents cités:
- FR-A1- 2 871 934
- US-A1- 2006 019 477
- US-A1- 2009 289 179

## Description

La présente invention concerne une machine d'implantation ionique en mode immersion plasma pour procédé basse pression.

Le domaine de l'invention est celui des machines d'implantation ionique qui mettent en oeuvre un plasma, autrement dit des implanteurs ioniques opérant en mode immersion plasma.

Ainsi, l'implantation ionique d'un substrat consiste à l'immerger dans un plasma et à le polariser en tension négative, de quelques dizaines de Volts à quelques dizaines de kilovolts (généralement moins de 100 kV), ceci de façon à créer un champ électrique capable d'accélérer les ions du plasma vers le substrat.

La profondeur de pénétration des ions est déterminée par leur énergie d'accélération. Elle dépend d'une part de la tension appliquée au substrat et d'autre part de la nature respective des ions et du substrat.

Pour des raisons liées à la physique, l'amorçage et l'entretien des plasmas nécessitent une pression relativement élevée, couramment 10⁻³ à 10⁻¹ mbar. Cette pression importante donne lieu à des effets secondaires indésirables. Le substrat est le siège d'une redéposition et d'une gravure inopportune. Par ailleurs, la consommation de gaz dépend directement de la pression de travail.

On a donc tenté de diminuer le plus possible cette pression. Cependant, cette diminution conduit à des difficultés d'amorçage du plasma et à une baisse sensible de sa densité.

Maintenant, on admet que la pression de travail optimale dépend du type de la source d'ionisation qui engendre et entretient le plasma :
- sources micro-ondes : 10⁻² à 10⁻¹ mbar,
- sources radiofréquences : 10⁻³ à 10⁻¹ mbar,

Les sources thermiques (sources à filaments) permettent de diminuer la pression mais elles donnent lieu à une contamination par vaporisation.

Les sources à décharge permettent également de travailler à plus basse pression, mais c'est au détriment de la densité du plasma.

Ainsi, le document US 2001/0046566 décrit une machine d'implantation ionique en mode immersion plasma comprenant :
- une enceinte qui est raccordée à un dispositif de pompage,
- un porte-substrat polarisé négativement qui est agencé dans l'enceinte,
- un dispositif d'alimentation plasma comportant une chambre pourvue d'une cellule d'ionisation, cette chambre ayant la forme d'un corps cylindroïde qui s'étend entre une section initiale et une section terminale débouchant dans l'enceinte,
la chambre étant munie d'un orifice d'approvisionnement en gaz,
la section terminale présentant une perte de charge par référence au corps.

Cette machine d'implantation permet de générer un plasma à pression relativement haute, ceci avec une réduction significative des effets secondaires mentionnés ci-dessus.

Toutefois, en premier lieu, la grille qui crée la perte de charge est optimisée pour des considérations électromagnétiques et non pas du point de vue de la perte de charge qu'elle engendre.

En second lieu, cette grille doit être conductrice et elle est donc réalisée dans un matériau métallique, ce qui peut conduire à une pollution du plasma. En effet, la grille va se graver au contact du plasma (gravure chimique et ionique). La contamination métallique qui résulte de cette gravure est incompatible avec certains domaines d'application tel que la microélectronique. De plus, les phénomènes de dépôt parasite sur les parois qui sont au contact du plasma, c'est-à-dire les parois de la chambre, sont significatifs.

En troisième lieu, la grille métallique vise à bloquer le champ électromagnétique d'allumage du plasma pour le confiner dans la chambre et l'empêcher de se propager dans l'enceinte où seuls les ions sont accélérés. Le champ électrostatique d'accélération des ions est créé entre le substrat et la grille et il impose la trajectoire de ces ions, ce qui empêche une implantation en trois dimensions dite « conforme » comme on peut l'obtenir grâce à une gaine de Child Langmuir lorsque le plasma est présent autour du substrat.

En quatrième lieu, la chambre débouche directement dans l'enceinte, ce qui n'est pas non plus favorable à la propagation du plasma dans cette enceinte.

La présente invention a ainsi pour objet d'améliorer cette situation. Le document US-A1-2006/0019477 divulgue une machine d'implantation ionique comportant une chambre inférieure raccordée à un dispositif de pompage, et une chambre supérieure s'étendant entre une section initiale et une section terminale. La chambre supérieure comprend une chambre principale pourvue d'un générateur de puissance RF et une chambre auxiliaire débouchant dans la chambre inférieure. Une grille sépare la chambre principale de la chambre auxiliaire, et permet la création d'une perte de charge.

Selon l'invention, une machine d'implantation ionique est définie par la revendication 1 et comprend :
- un dispositif de pompage,
   - une enceinte qui est raccordée au dispositif de pompage,
   - un porte-substrat agencé dans cette enceinte,
- une alimentation électrique haute tension configurée pour polariser négativement le porte-substrat,
   - un dispositif d'alimentation plasma ayant la forme d'un corps cylindroïde qui s'étend entre une section initiale et une section terminale, ce dispositif comportant une chambre principale pourvue d'une cellule d'ionisation,
   cette chambre principale étant munie d'un orifice d'approvisionnement en gaz,
   la section finale de la chambre principale étant pourvue de moyens d'amoindrissement configurés pour créer une perte de charge par référence au corps ;
   de plus, ce dispositif d'alimentation plasma comporte également une chambre auxiliaire disposée au-delà de la section finale, cette chambre auxiliaire débouchant dans ladite enceinte (ENV) au niveau de ladite section terminale, ladite chambre auxiliaire étant pourvue d'une seconde cellule d'ionisation.

Avantageusement, le dispositif d'alimentation plasma présente un volume inférieur à celui de l'enceinte.

Suivant un premier mode de réalisation, la section finale a la forme d'une cloison percée d'une pluralité de trous.

Suivant un deuxième mode de réalisation, la section finale présente une ouverture de surface réduite par référence à la surface de l'une quelconque des sections du corps comprise entre la section initiale et la section terminale.

Suivant une caractéristique additionnelle de l'invention, la première cellule d'ionisation comporte une bobine d'excitation et une bobine de confinement.

Il est souhaitable que l'axe du porte-substrat et l'axe du dispositif d'alimentation plasma soient deux axes distincts.

En ce cas, le plateau porte-substrat et le dispositif d'alimentation plasma présentent un désaxage qui est de préférence réglable.

Suivant un autre avantage de l'invention, la section finale est démontable.

Eventuellement, la machine comporte au moins un dispositif d'alimentation plasma additionnel.

Avantageusement, l'alimentation électrique haute tension comprend :
- un générateur de tension dont le pôle positif est connecté à la masse,
- un condensateur monté en parallèle sur ledit générateur de tension,
- un interrupteur connecté entre le pôle négatif du générateur de tension et le plateau porte-substrat.

D'autre part, le plateau porte-substrat est mobile en rotation autour de son axe.

Par ailleurs, le plateau porte-substrat prenant la forme d'un disque, la distance entre ce plateau porte-substrat et le dispositif d'alimentation plasma est supérieure au diamètre du porte-substrat.

De préférence, les moyens d'amoindrissement sont électriquement isolants.

La présente invention apparaîtra maintenant avec plus de détails dans le cadre de la description qui suit d'exemples de réalisation donnés à titre illustratif en se référant aux figures jointes parmi lesquelles :
- la figure 1 représente un schéma en coupe d'une machine d'implantation ionique,
- la figure 2 représente un circuit de polarisation du plateau porte-substrat, plus particulièrement :
   - la figure 2a, un premier mode de réalisation de ce circuit,
   - la figure 2b, un deuxième mode de réalisation de ce circuit,
- la figure 3 représente un schéma en coupe d'un deuxième mode de réalisation du dispositif d'alimentation plasma.

Les éléments présents sur plusieurs figures sont affectés d'une seule et même référence.

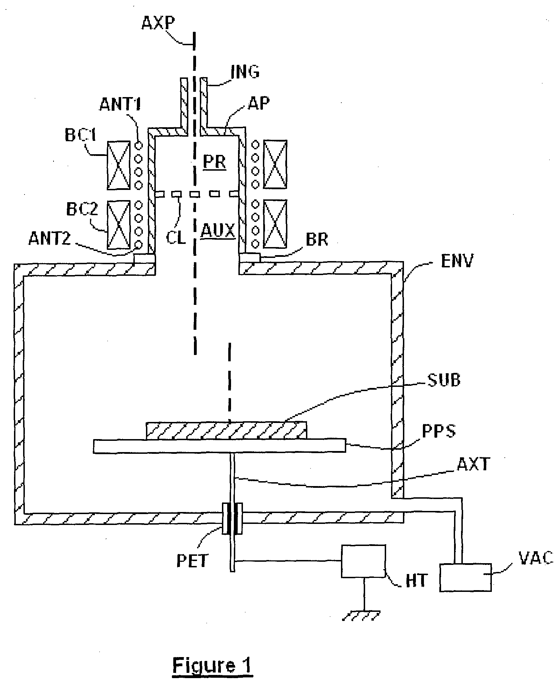

Tel que représenté sur la figure 1, une enceinte à vide ENV symbolise une machine d'implantation ionique. Pour les applications microélectroniques, il est préconisé d'utiliser une enceinte en alliage d'aluminium si l'on souhaite limiter la contamination en éléments métalliques tels que Fer, Chrome, Nickel ou Cobalt. Un revêtement en silicium ou en carbure de Silicium peut aussi être utilisé.

Des moyens de pompage VAC sont disposés à la partie inférieure de l'enceinte ENV.

Un plateau porte-substrat PPS, se présentant sous la forme d'un disque horizontal, mobile autour de son axe vertical AXT, reçoit le substrat SUB devant subir l'implantation ionique. Il est relié à une alimentation électrique haute tension HT par un passage électrique haute tension PET, cette alimentation étant d'autre part raccordée à la masse. Le potentiel négatif appliqué au porte-substrat est généralement compris entre quelques dizaines de volts et quelques dizaines de kilovolts.

Classiquement, cette alimentation peut consister en un simple générateur de tension continue dont le pôle positif est raccordé à la masse. Cependant l'invention s'applique quel que soit le moyen d'appliquer une polarisation négative au substrat dans le cadre de l'implantation en mode immersion plasma, que cette polarisation soit constante ou variable. En effet, le substrat, en particulier s'il est isolant, tend à se charger positivement.

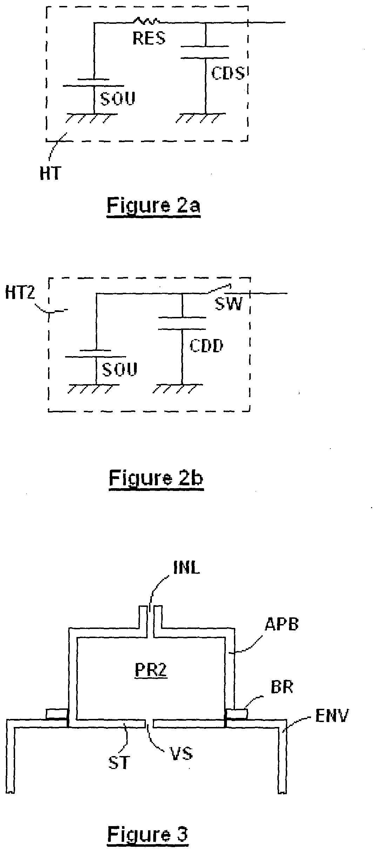

En référence à la figure 2a, un premier mode de réalisation de cette alimentation HT permet de limiter l'effet de charge. Elle comporte un générateur de tension continue SOU dont le pôle positif est raccordé à la masse. Une branche de dérivation qui est montée en parallèle sur ce générateur est formée d'un condensateur CDS et d'une résistance RES en série, cette résistance étant connectée au pôle négatif du générateur SOU. Le plateau porte-substrat PPS est connecté au point commun entre le condensateur CDS et la résistance RES.

Le condensateur CDS présente une capacité de faible valeur afin de faire revenir progressivement le potentiel du substrat à une valeur voisine de zéro lors de sa phase de décharge.

En effet, même si l'utilisation d'un plasma pulsé permet la limitation de l'effet de charge, ce problème demeure surtout si le potentiel du substrat reste très négatif pendant le procédé (cas de l'utilisation d'un condensateur de forte capacité).

Dans le cas de l'utilisation d'un condensateur de faible capacité et d'une impulsion plasma suffisamment longue, il se produit le phénomène suivant :
- au début de l'impulsion, le condensateur est chargé, le potentiel du substrat est fixé par la tension de charge et les ions sont accélérés vers le substrat selon le mécanisme décrit précédemment ;
- la tension aux bornes du condensateur chute car celui-ci se décharge dans le plasma ;
- au-dessus d'un certain potentiel, que nous nommerons potentiel d'inversion, les charges positives accumulées sur les zones isolantes génèrent un champ électrique alors prédominant qui attire les électrons du plasma ; il y a alors neutralisation de ces charges positives et suppression des risques d'arcage.

Cette neutralisation est d'autant plus efficace que la pression de travail est faible. En effet, si le libre parcours moyen des électrons est important, le flux d'électrons qui atteint la surface pour neutraliser l'effet de charge est lui aussi conséquent.

Les conditions nécessaires à l'établissement de ce mécanisme sont donc :
- capacité du condensateur CDS suffisamment faible,
- durée de l'impulsion plasma suffisamment longue pour atteindre le potentiel d'inversion avant que les charges accumulées en surface ne causent des arcages, et
- pression de travail suffisamment faible pour que le libre parcours moyen des électrons créés par la source plasma leurs permettent d'atteindre le substrat sans risque de collision et de recombinaison avec les molécules de gaz et les ions présents dans l'enceinte.

La résistance RES a pour fonction de limiter le courant au début de la charge du condensateur CDS. De plus, si cette résistance est supérieure à l'impédance équivalente du plasma, elle permet également de limiter la recharge de ce condensateur pendant l'impulsion plasma où l'on désire la décharger.

Pour une impédance plasma typiquement égale à 100 kΩ, la résistance de charge sera préférentiellement comprise entre 200 kΩ et 2 000 kΩ. La capacité du condensateur CDS est telle que sa décharge est pratiquement complète à la fin d'une impulsion plasma.

Les paramètres couramment utilisés dans ce mode sont :
- densité plasma comprise entre 10⁸ et 10¹⁰/cm³,
- durée d'impulsion plasma comprise entre 15 µs et 500 µs,
- fréquence de répétition des impulsions comprise entre 1 Hz et 3 kHz,
- pression de travail comprise entre 2.10⁻⁴ et 5.10⁻³ mbar,
- gaz employé : N₂, BF₃, O₂, H₂, PH₃, AsH₃, ou Ar,
- résistance RES supérieure à 300 kΩ,
- capacité CDS de 500 pF,
- tension de polarisation comprise entre - 100 et - 10 000 Volts.

En référence à la figure 2b, un deuxième mode de réalisation de l'alimentation HT2 permet lui aussi de limiter l'effet de charge. Cette alimentation comporte un générateur de tension continue SOU dont le pôle positif est raccordé à la masse. Un condensateur CDD est monté en parallèle sur ce générateur. Un interrupteur SW est connecté entre le pôle négatif du générateur SOU et le plateau porte-substrat PPS. Cet interrupteur SW est réalisé en technologie « MOS » (pour Metal Oxyde Semiconductor en anglais) ou en technologie « IGBT » (pour Insulated Gate Bipolar Transistor en anglais).

Lorsque l'interrupteur SW est ouvert, le condensateur CDD se charge progressivement à la tension nominale du générateur SOU.

Lorsque l'on ferme cet interrupteur SW alors que le plasma est allumé, il s'ensuit un appel du courant dû à la capacité équivalente de la machine et à la capacité de la gaine plasma. La capacité équivalente de la machine est celle de tous les éléments qui la composent, notamment les câbles, les passages électriques, les transformateurs d'isolation et celle qui est formée entre le porte-substrat et l'enceinte.

L'interrupteur SW reste fermé typiquement entre 5 µs et 100 µs, phase pendant laquelle se produit l'implantation car les ions positifs sont attirés vers le substrat qui est polarisé négativement.

Le condensateur présente une forte capacité (typiquement entre 300 nF et 1,5 µF) de sorte que la tension à ses bornes ne chute pas lors de l'implantation.

Après la phase d'implantation, l'interrupteur SW est ouvert et le générateur SOU charge à nouveau le condensateur CDD.

Pendant ce temps, la capacité équivalente de la machine se décharge totalement dans le plasma et le substrat revient à un potentiel flottant. Il s'ensuit que les électrons du plasma viennent neutraliser les zones isolantes du substrat qui se sont chargées positivement au cours de l'implantation.

La phase de neutralisation durant laquelle l'interrupteur SW reste ouvert dure typiquement de 1 µs à 80 µs.

Une fois la phase de neutralisation achevée, le plasma peut être éteint durant une phase d'extinction, ce qui présente l'avantage de réduire les interactions plasma/surface, de réduire le budget thermique et de minimiser la création de particules. Cette phase d'extinction dure typiquement de 20 µs à 200 µs, phase pendant laquelle l'interrupteur SW reste ouvert.

Il est alors possible de répéter le cycle décrit ci-dessus :
- phase d'implantation,
- phase de neutralisation,
- phase d'extinction.

On peut raccourcir la phase de neutralisation en accélérant la décharge de la capacité équivalente de la machine au moyen d'un second interrupteur agencé entre le plateau porte-substrat PPS et la masse. Ce second interrupteur est fermé au cours de la phase de neutralisation et pendant la phase d'extinction ; il est ouvert pour la phase d'implantation.

En revenant à la figure 1, la partie supérieure de l'enceinte ENV reçoit le dispositif d'alimentation plasma AP. Ce dispositif se présente comme un corps cylindroïde d'axe vertical AXP qui s'étend entre une section initiale (en haut sur la figure) et une section terminale (en bas sur la figure). Une bride de raccordement BR permet de fixer la section terminale du dispositif AP sur l'enceinte à vide ENV. La section initiale est munie d'un orifice d'approvisionnement ING pour l'introduction du gaz qui donne naissance au plasma. Cet orifice d'approvisionnement ING est centré sur l'axe vertical AXP. Cet axe vertical AXP rencontre la surface du plateau porte-substrat PPS.

Le dispositif d'alimentation plasma AP est de préférence en silice fondue (couramment dénommée quartz à tort) ou en alumine pour limiter les problèmes de contamination. Des moyens d'amoindrissement pour créer une perte de charge sont prévus qui consistent ici en une cloison CL percée d'une pluralité de trous débouchants. Cette cloison CL avantageusement électriquement isolante, en silice fondue de préférence, est agencée entre la section initiale et la section terminale de ce dispositif AP. A titre d'exemple, pour un corps cylindrique ayant un diamètre de l'ordre de 15 cm, les trous de la cloison CL ont un diamètre de l'ordre de quelques mm. Pour faciliter les opérations de maintenance, la cloison CL est démontable.

L'espace délimité par cette cloison CL et la section initiale définit une chambre principale PR. La cloison CL matérialise donc la section finale de la chambre principale. Cette chambre principale PR est extérieurement entourée par une cellule d'ionisation qui comporte, d'une part une antenne radiofréquence ANT1 et, accessoirement, d'autre part une bobine de confinement BC1. Cette antenne ANT1 est ici constituée par quelques spires d'un conducteur électrique, un tube ou une lame de cuivre par exemple.

Il est bien sûr possible d'utiliser tout type de source plasma : décharge, ICP (pour « Inductively Coupled Plasma » en anglais), hélicon, micro-ondes, arc. Ces sources doivent travailler à des niveaux de pression suffisamment faibles pour que le champ électrique créé entre le plateau PPS et l'enceinte ENV à la masse n'allume pas un plasma de décharge.

La perte de charge entre le corps du dispositif d'alimentation plasma AP et l'enceinte ENV permet d'établir une différence de pression entre ces deux éléments qui soit comprise entre un et deux ordres de grandeur.

L'espace délimité par cette cloison CL et la section terminale définit une chambre auxiliaire AUX.

Cette chambre auxiliaire AUX est elle aussi extérieurement entourée d'une deuxième cellule d'ionisation qui comporte, d'une part une bobine de confinement BC2, et d'autre part une antenne radiofréquence ANT2.

On pourrait également prévoir une seule bobine de confinement et une seule antenne recouvrant les deux chambres PR, AUX, du dispositif AP.

N'importe quelle espèce plasmagène peut être implantée. Il est possible de partir d'un précurseur gazeux tel N₂, O₂, H₂, He, Xe, Ar, BF₃, B₂H₆, AsH₃, PH₃, SiH₄, GeH₄, C₂H₄, SiF₄, GeF₄, AsF₅, CHF₃, SF₆, PF₅.

Un tel agencement permet de diminuer de façon très importante les phénomènes parasites de dépôt et de gravure.

Les paramètres typiques du plasma sans la mise en oeuvre de l'invention sont les suivants :
- débit de gaz: 10 à 500 sccm (« standard cubic centimeters per minute ») ou en français centimètres cube par minute dans les conditions standard de pression et de température ;
- pression dans l'enceinte à vide : 10⁻³ à 10⁻¹ mbar ;
- densité du plasma : 10⁹ à 10¹¹ par centimètres cube.

L'invention améliore notablement cette situation car elle permet d'obtenir les valeurs suivantes :
- débit de gaz : 0,5 à 50 sccm ;
- pression dans l'enceinte à vide : de l'ordre de 10⁻⁴ à 10⁻² mbar;
- densité du plasma : 10⁹ à 10¹¹ par centimètres cube.

Ces résultats sont obtenus grâce à la cloison CL qui introduit une perte de charge conséquente entre l'endroit où est généré le plasma, la chambre principale PR, et l'endroit où ce plasma est utilisé. On peut ainsi conserver une pression de l'ordre de 10⁻³ à 10⁻¹ mbar dans la chambre principale tout en réduisant sensiblement cette pression dans l'enceinte à vide ENV. La pression régnant dans la chambre principale permet un allumage aisé du plasma. Les électrons de ce plasma vont alors pouvoir, sous l'effet des champs électrostatiques appliqués par la cellule d'ionisation, atteindre l'enceinte à vide ENV à travers la cloison CL et provoquer l'allumage et la propagation du plasma dans cette dernière.

Cette perte de charge constitue l'essence de l'invention. Elle peut être réalisée de bien des manières.

En référence à la figure 3, on donne un deuxième mode de réalisation du dispositif d'alimentation plasma à titre indicatif.

Le dispositif d'alimentation plasma APB se présente toujours comme un corps cylindroïde qui s'étend entre une section initiale et une section terminale. La bride de raccordement BR a toujours la même fonction, à savoir la fixation de la section terminale du dispositif APB sur l'enceinte à vide. Comme auparavant, la section initiale est munie d'un orifice d'approvisionnement INL pour l'introduction du gaz. Par contre, la perte de charge n'est pas obtenue au moyen d'une cloison percée. Ici, le corps du dispositif APB constitue la chambre principale PR2. Il n'y a plus de chambre auxiliaire et c'est la section terminale ST elle-même qui présente une ouverture VS dont la surface est très réduite par comparaison à la surface de la section médiane du dispositif APB.

En revenant à la figure 1, une caractéristique additionnelle de l'implanteur 1 permet d'uniformiser l'implantation pour un substrat de grande taille.

Comme évoqué précédemment, le substrat SUB repose sur un plateau porte-substrat PPS généralement discoïdal et mobile autour de son axe vertical AXT. Avec ou sans rotation, si l'axe AXP du dispositif d'alimentation plasma ALP surplombant le substrat SUB est proche de l'axe AXT du plateau PPS, la diffusion plasma sera maximale le long de cet axe, et présentera un gradient de répartition par rapport à cet axe. La dose implantée dans le substrat SUB présentera une répartition non homogène.

Si les deux axes AXT, AXP présentent un désaxage, la rotation du plateau porte-substrat PPS permet de déplacer le substrat SUB par rapport à l'axe AXP de la source plasma. La dose implantée dans le substrat SUB présentera une répartition dont l'homogénéité sera sensiblement améliorée.

L'efficacité de ce système a été vérifiée sur des tranches de silicium de diamètre 300 mm pour lesquelles la non-homogénéité obtenue s'est avérée inférieure à 1% pour une implantation de BF₃ à 500 eV et 10¹⁵/cm².

Par ailleurs, la distance entre le plateau porte-substrat PPS et le dispositif d'alimentation plasma AP est de préférence supérieure au diamètre de ce porte-substrat dans le cas général où celui-ci prend la forme d'un disque.

Naturellement, la présente invention permet d'implémenter plusieurs dispositifs d'alimentation plasma tels que ceux décrits ci-dessus, ces dispositifs étant répartis sur l'enceinte ENV autour de l'axe vertical AXT du plateau porte-substrat PPS.

Le dispositif d'alimentation plasma a été présenté jusqu'à présent comme un composant rapporté sur une enceinte à vide. L'invention s'applique naturellement si ce dispositif fait partie intégrante de l'enceinte.

Les exemples de réalisation de l'invention présentés ci-dessus ont été choisi eu égard à leur caractère concret. Il ne serait cependant pas possible de répertorier de manière exhaustive tous les modes de réalisation que recouvre cette invention. En particulier, tout moyen décrit peut être remplacé par un moyen équivalent sans sortir du cadre de la présente invention. L'invention est définie par les revendications.

## Revendications

1. Machine d'implantation ionique comprenant:
- un dispositif de pompage (VAC),
- une enceinte (ENV) qui est raccordée au dispositif de pompage (VAC),
- un porte-substrat (PPS) agencé dans ladite enceinte
- une alimentation électrique haute tension (HT) configurée pour polariser négativement le porte-substrat (PPS),
- un dispositif d'alimentation plasma (AP) ayant la forme d'un corps cylindroïde qui s'étend entre une section initiale et une section terminale, ce dispositif comportant une chambre principale (PR, PR2) pourvue d'une cellule d'ionisation (BC1, ANT1),
ladite chambre principale (PR, PR2) étant munie d'un orifice (ING, INL) d'approvisionnement en gaz, la section finale (CL) de ladite chambre principale étant pourvue de moyens d'amoindrissement configurés pour créer une perte de charge par référence audit corps (AP), ledit dispositif d'alimentation plasma (AP) comportant également une chambre auxiliaire (AUX) disposée au-delà de ladite section finale, cette chambre auxiliaire débouchant dans ladite enceinte (ENV) au niveau de ladite section terminale,
**caractérisée en ce que** ladite chambre auxiliaire (AUX) est pourvue d'une seconde cellule d'ionisation (BC2, ANT2).

2. Machine selon la revendication 1, **caractérisée en ce que** ledit dispositif d'alimentation plasma (AP) présente un volume inférieur à celui de ladite enceinte (ENV).

3. Machine selon l'une quelconque des revendications 1 ou 2, **caractérisée en ce que** ladite section finale a la forme d'une cloison (CL) percée d'une pluralité de trous.

4. Machine selon l'une quelconque des revendications 1 ou 2, **caractérisée en ce que** ladite section finale (ST) présente une ouverture (VS) de surface réduite par référence à la surface de l'une quelconque des sections dudit corps (APB) comprise entre ladite section initiale et ladite section terminale.

5. Machine selon l'une quelconque des revendications précédentes, **caractérisée en ce que** ladite première cellule d'ionisation comporte une bobine d'excitation (ANT1) et une bobine de confinement (BC1).

6. Machine selon l'une quelconque des revendications précédentes, **caractérisée en ce que** l'axe (AXT) dudit porte-substrat (PPS) et l'axe (AXP) dudit dispositif d'alimentation plasma (AP) sont deux axes distincts.

7. Machine selon la revendication 6, **caractérisée** en que ledit plateau porte-substrat (PPS) et ledit dispositif d'alimentation plasma (AP) présentent un désaxage réglable.

8. Machine selon l'une quelconque des revendications précédentes, **caractérisée en ce que** ladite section finale est démontable.

9. Machine selon l'une quelconque des revendications précédentes, **caractérisée en ce qu'**elle comporte au moins un dispositif d'alimentation plasma additionnel.

10. Machine selon l'une quelconque des revendications précédentes, **caractérisée** en que l'alimentation électrique haute tension (HT) comprend :
- un générateur de tension (SOU) dont le pôle positif est connecté à la masse,
- un condensateur (CDD) monté en parallèle sur ledit générateur de tension (SOU),
- un interrupteur (SW) connecté entre le pôle négatif dudit générateur de tension (SOU) et ledit plateau porte-substrat (PPS).

11. Machine selon l'une quelconque des revendications précédentes, **caractérisée** en que ledit plateau porte-substrat (PPS) est mobile en rotation autour de son axe (AXT).

12. Machine selon l'une quelconque des revendications précédentes **caractérisée** en que, ledit plateau porte-substrat (PPS) prenant la forme d'un disque, la distance entre ce plateau porte-substrat et ledit dispositif d'alimentation plasma (AP) est supérieure au diamètre dudit porte-substrat.

13. Machine selon l'une quelconque des revendications précédentes, **caractérisée** en que lesdits moyens d'amoindrissement (CL, VS) sont électriquement isolants.

## Patentansprüche

1. Ionenimplantationsmaschine, umfassend
- eine Pumpvorrichtung (VAC),
- eine Kammer (ENV), die mit der Pumpvorrichtung (VAC) verbunden ist,
- einen Substratträger (PPS), der in der Kammer angeordnet ist,
- eine Hochspannungsstromversorgung (HT), die dazu konfiguriert ist, den Substratträger (PPS) negativ zu polarisieren,
- eine Plasmaversorgungsvorrichtung (AP), welche die Form eines zylinderähnlichen Körpers hat, der sich zwischen einem Anfangsabschnitt und einem Endabschnitt erstreckt, wobei diese Vorrichtung einen Hauptraum (PR, PR2) aufweist, der mit einer Ionisationszelle (BC1, ANT1) versehen ist,
wobei der Hauptraum (PR, PR2) mit einer Gaszuleitungsöffnung (ING, INL) ausgestattet ist,
wobei der abschließende Abschnitt (CL) des Hauptraums mit Minderungsmitteln versehen ist, die dazu konfiguriert sind, einen Druckverlust in Bezug auf den Körper (AP) zu erzeugen,
wobei die Plasmaversorgungsvorrichtung (AP) auch einen Hilfsraum (AUX) aufweist, der jenseits des abschließenden Abschnitts angeordnet ist, wobei der Hilfsraum auf Höhe des Endabschnitts in die Kammer (ENV) mündet,
**dadurch gekennzeichnet, dass** der Hilfsraum (AUX) mit einer zweiten Ionisationszelle (BC2, ANT2) versehen ist.

2. Maschine nach Anspruch 1, **dadurch gekennzeichnet, dass** die Plasmaversorgungsvorrichtung (AP) ein geringeres Volumen als das der Kammer (ENV) aufweist.

3. Maschine nach einem der Ansprüche 1 oder 2, **dadurch gekennzeichnet, dass** der abschließende Abschnitt die Form einer Trennwand (CL) hat, die mit einer Vielzahl von Löchern durchbohrt ist.

4. Maschine nach einem der Ansprüche 1 oder 2, **dadurch gekennzeichnet, dass** der abschließende Abschnitt (ST) eine Öffnung (VS) mit reduzierter Fläche in Bezug auf die Fläche eines der Abschnitte des Körpers (APB) zwischen dem Anfangsabschnitt und dem Endabschnitt aufweist.

5. Maschine nach einem der vorhergehenden Ansprüche, **dadurch gekennzeichnet, dass** die erste Ionisationszelle eine Erregerspule (ANT1) und eine Einschlussspule (BC1) aufweist.

6. Maschine nach einem der vorhergehenden Ansprüche, **dadurch gekennzeichnet, dass** die Achse (AXT) des Substratträgers (PPS) und die Achse (AXP)der Plasmaversorgungsvorrichtung (AP) zwei verschiedene Achsen sind.

7. Maschine nach Anspruch 6, **dadurch gekennzeichnet, dass** die Substratträgerplatte (PPS) und die Plasmaversorgungsvorrichtung (AP) einen verstellbaren Achsversatz aufweisen.

8. Maschine nach einem der vorhergehenden Ansprüche, **dadurch gekennzeichnet, dass** der abschließende Abschnitt demontierbar ist.

9. Maschine nach einem der vorhergehenden Ansprüche, **dadurch gekennzeichnet, dass** sie mindestens eine zusätzliche Plasmaversorgungsvorrichtung aufweist.

10. Maschine nach einem der vorhergehenden Ansprüche, **dadurch gekennzeichnet, dass** die Hochspannungsstromversorgung (HT) umfasst:
- einen Spannungsgenerator (SOU), dessen Pluspol an die Masse angeschlossen ist,
- einen Kondensator (CDD), der parallel zu dem Spannungsgenerator (SOU) geschaltet ist,
- einen Schalter (SW), der zwischen den Minuspol des Spannungsgenerators (SOU) und die Substratträgerplatte (PPS) geschaltet ist.

11. Maschine nach einem der vorhergehenden Ansprüche, **dadurch gekennzeichnet, dass** die Substratträgerplatte (PPS) um seine Achse (AXT) drehbeweglich ist.

12. Maschine nach einem der vorhergehenden Ansprüche, **dadurch gekennzeichnet, dass**, wenn die Substratträgerplatte (PPS) die Form einer Scheibe annimmt, der Abstand zwischen dieser Substratträgerplatte und der Plasmaversorgungsvorrichtung (AP) größer als der Durchmesser des Substratträgers ist.

13. Maschine nach einem der vorhergehenden Ansprüche, **dadurch gekennzeichnet, dass** die Minderungsmittel (CL, VS) elektrisch isolierend sind.

## Claims

1. An ion implantation machine comprising:
- a pump device (VAC),
- an enclosure (ENV) that is connected to the pump device (VAC),
- a substrate-carrier (PPS) arranged inside said enclosure (ENV),
- a high voltage electrical power supply (HT) arranged to polarize negatively the substrate-carrier (PPS),
- a plasma feed device (AP) in the form of a cylindrical body extending between an initial section and a terminal section, this device having a main chamber (PR, PR2) provided with an ionization cell (BC1, ANT1), said main chamber (PR, PR2) being provided with a gas delivery orifice (ING, INL),
the final section (CL) of said main chamber being provided with head-loss means arranged for creating a pressure drop relative to said body (AP),
said plasma feed device (AP) also having an auxiliary chamber (AUX) arranged beyond said final section, this auxiliary chamber opening out into said enclosure (ENV) at said terminal section, **characterized in that** said auxiliary chamber (AUX) is provided with a second ionization cell (BC2, ANT2).

2. A machine according to claim 1, **characterized in that** said plasma feed device (AP) presents a volume that is smaller than the volume of said enclosure (ENV).

3. A machine according to any one of claims 1 or 2, **characterized in that** said final section is in the form of a partition (CL) pierced by a plurality of holes.

4. A machine according to any one of claims 1 or 2, **characterized in that** said final section (ST) presents an opening (VS) of area that is small relative to the area of any of the sections of said body (APB) lying between said initial section and said terminal section.

5. A machine according to any one of preceding claims, **characterized in that** said first ionization cell has an excitation coil (ANT1) and a confinement coil (BC1).

6. A machine according to any one preceding claims, **characterized in that** the axis (AXT) of said substrate-carrier (PPS) and the axis (AXP) of said plasma feed device (AP) are two distinct axes.

7. A machine according to claim 6, **characterized in that** said substrate-carrier (PPS) and said plasma feed device (AP) present an adjustable offset.

8. A machine according to any one of preceding claims, **characterized in that** said final section is removable.

9. A machine according to any one of preceding claims, **characterized in that** it includes at least one additional plasma feed device.

10. A machine according to any one of preceding claims, **characterized in that** the high voltage electrical power supply (HT) comprises:
- •a voltage source (SOU) having its positive pole connected to ground,
- •a capacitor (CDD) connected in parallel with said voltage source (SOU),
- •a switch (SW) connected between the negative pole of said voltage source (SOU) and said substrate-carrier turntable (PPS).

11. A machine according to any one of preceding claims, **characterized in that** said substrate-carrier (PPS) turntable is movable in rotation about its axis (AXT).

12. A machine according to any one of preceding claims, **characterized in that** said substrate-carrier (PPS) turntable is disk-shaped and the distance between this substrate-carrier turntable and said plasma feed device (AP) is greater than the diameter of said substrate-carrier.

13. A machine according to any one of preceding claims, **characterized in that** said head-loss means (CL, VS) are electrically insulating.
